# EUROPÄISCHE PATENTANMELDUNG

(11) **EP 4 181 639 A1**
(43) Veröffentlichungstag der Anmeldung: **17.05.2023**
(21) Anmeldenummer: 21207410.8
(22) Anmeldetag: 10.11.2021
(51) Int. Cl.: H05K 5/00, H01H 9/18

(54) **VORRICHTUNGEN UND VERFAHREN ZUR MONTAGE EINER MEHRFACHANZEIGEBAUGRUPPE**

(71) Anmelder: epis Automation GmbH & Co. KG, 72458 Albstadt (DE)
(72) Erfinder: KUCHELMEISTER, Lutz, 72514 Inzigkofen (DE)
(74) Vertreter: Patent- und Rechtsanwälte Behrmann Wagner PartG mbB

(57) **Zusammenfassung**

Die Erfindung betrifft eine Hilfsvorrichtung (1) zur Montage einer Mehrfachanzeigebaugruppe (2) in einer Bedien- und Steuervorrichtung (17), bevorzugt für eine Werkzeugmaschine. Erfindungsgemäß ist ein, bevorzugt plattenförmiger, Grundkörper (3) vorgesehen, wobei der Grundkörper (3) eine Vielzahl von Vertiefungen (5) für die Aufnahme von Anzeigeelementen (7) aufweist und der Grundkörper (3) wenigstens zwei Justage-Ausnehmungen (6), bevorzugt Durchbrüche, aufweist, mit denen der Grundkörper (3) im montierten Zustand an oder in der Bedien- und Steuervorrichtung (17), insbesondere an Schaltelementen (16) der Bedien- und Steuervorrichtung (17), ausgerichtet wird.

## Beschreibung

Die vorliegende Erfindung betrifft eine Hilfsvorrichtung zur Montage einer Mehrfachanzeigebaugruppe in einer Bedien- und Steuervorrichtung, bevorzugt für eine Werkzeugmaschine, nach dem Oberbegriff des Anspruchs 1. Weiter betrifft die vorliegende Erfindung eine Mehrfachanzeigebaugruppe mit einer entsprechenden Hilfsvorrichtung oder Montagehilfsvorrichtung. Weiter betrifft die vorliegende Erfindung eine Bedien- und Steuervorrichtung, bevorzugt für eine Werkzeugmaschine. Schließlich betrifft die vorliegende Erfindung ein Verfahren zur Montage einer Vielzahl von Anzeigeelementen in einer Bedien- und Steuervorrichtung, insbesondere für eine Werkzeugmaschine.

Aus dem Stand der Technik sind bereits Bedien- und Steuervorrichtungen, insbesondere für Werkzeugmaschinen, bekannt, bei denen zur Umsetzung von Schutz- und Sicherheitsmaßnahmen gewisse Bedienelemente oder Eingabeelemente als physische Schalter ausgebildet sind oder ausgebildet sein müssen. Dies bedeutet, dass die Schalter oder Schaltelemente gerade nicht nur rein softwaremäßig umgesetzt werden dürfen, beispielsweise im Rahmen einer berührungsempfindlichen, optischen Ein- und Ausgabeschnittstelle, wie beispielsweise einem Touchscreen, sondern das klassische Schalter oder Schaltelemente vorgesehen sein müssen, um zumindest ein Teil der Bedienelemente zu realisieren. Für derartige Bedien- und Steuervorrichtungen hat sich in der Vergangenheit jedoch nichtsdestotrotz ein Grundkonzept als vorteilhaft erwiesen, bei dem neben den zwangsläufig zur realisierenden physischen oder physikalischen Schaltelementen auch variabel einsetzbare oder programmierbare Anzeigeelemente eingesetzt werden, um den physischen Schaltelementen unterschiedliche Funktionen zuzuordnen und dies über die Anzeigeelemente verdeutlichen zu können.

Die variablen Anzeigeelemente können einerseits als berührungsempfindliche, optische Ein- und Ausgabeschnittstelle vorgesehen sein, über die jedoch dann gerade keine Einstellungen oder Veränderungen vorgenommen werden können, die sicherheitsbedingt über einen physikalischen Schalter vorgenommen oder umgesetzt werden können. Um das Bedienkonzept trotzdem möglichst variabel auszugestalten und, trotzdem mit einer möglichst geringen Anzahl an physischen oder physikalischen Schaltern oder Schaltelementen auskommen zu können, ist im Stand der Technik zudem bereits der Einsatz von programmierbaren und dementsprechend in ihrem Anzeige- oder Ausgabegehalt veränderlichen Ausgabe- oder Anzeigeeinheiten bekannt, die den physischen Schaltelementen so räumlich benachbart oder ansonsten räumlich zugeordnet angeordnet sind, dass eine Beschriftung oder eine sonstige bildliche, beispielsweise in Form eines Piktogramms, dargestellte Information zur Verdeutlichung oder Veranschaulichung der aktuellen Funktionalität des Schalters oder Schaltelements abhängig von einem Betriebs- oder Eingabemodus geändert und angezeigt werden kann, wobei der Betriebs- oder Eingabemodus dann über ein zentrales Auswahlbedienelement, beispielsweise über eine berührungsempfindliche, optische Ein- und Ausgabeschnittstelle bedient wird und in dem jeweiligen Zustand oder Bedienmodus den physikalischen Schaltern oder Schaltelementen unterschiedlichen Funktionen zugewiesen werden, die über eine Beschriftung oder entsprechende Piktogramme über die benachbarten oder ansonsten zugeordneten Anzeigeelemente verdeutlicht oder beschrieben werden.

Eine entsprechende Bedien- und Steuervorrichtung ist beispielsweise aus der DE 10 2018 124 087 A1 bekannt und dort als Mensch-Maschine-Steuerung tituliert oder bezeichnet.

Bei der Montage der dort zum Beschriften oder Identifizieren der jeweiligen Schalter oder Schalterfunktionalität im jeweiligen, veränderbaren Bedienmodus vorgesehenen Anzeigeelemente sind jedoch im Stand der Technik Schwierigkeiten und Nachteile bekannt.

Einerseits können die Anzeigeelemente, beispielsweise im Fall einer Störung oder eines Ausfalls nicht einzeln, zerstörungsfrei und darüber hinaus einfach gewechselt werden, wenn die Anzeigeelemente im Wesentlichen von innen an der jeweiligen, dem Schaltelement benachbarten oder zugeordneten Position an einem Frontelement, insbesondere einer Frontschreibe der Bedien- und Steuervorrichtung befestigt, insbesondere verklebt, werden. Außerdem hat eine solche Anbringung das Problem der präzisen Positionierung der Anzeigeelemente gegenüber dem Frontelement, insbesondere der Frontscheibe der Bedient- und Steuervorrichtung. Denn das Frontelement, insbesondere die Frontschreibe ist in der Regel maskiert oder ansonsten vorbereitet, sodass die Anordnung der Anzeigeelemente in einem bestimmten Bereich und mit einer bestimmten Ausrichtung und dort innerhalb enger Toleranzen erfolgen muss, um sowohl im Hinblick auf die optische Erscheinung als auch im Hinblick auf die korrekte Funktionsweise eine gewünschte und erforderliche Montage der Anzeigeelemente zu gewährleisten.

Schließlich ist die Montage der Anzeigeelemente in der Bedien- und Steuervorrichtung auch verhältnismäßig aufwendig, wenn die Anzeigeelemente jeweils einzeln und, wie vorangehend beschrieben, mit einer entsprechend hohen Präzision im Hinblick auf Position und Ausrichtung in der Bedien- und Steuervorrichtung, insbesondere an einem Frontelement oder einer Frontscheibe angeordnet und befestigt werden müssen.

Ausgehend von diesem Stand der Technik liegt die Aufgabe der vorliegenden Erfindung darin, Vorrichtungen und Verfahren bereitzustellen, mit denen die Nachteile im Stand der Technik überwunden, und insbesondere eine schnelle, genaue und reversible Montage der Anzeigeelemente in einer entsprechenden Bedien- und Steuervorrichtung erlauben.

Gelöst wird diese Aufgabe im Hinblick auf eine Hilfsvorrichtung zur Montage einer Mehrfachanzeigebaugruppe mit den Merkmalen des Anspruchs 1. Im Hinblick auf eine Mehrfachanzeigebaugruppe wird die Aufgabe mit den Merkmalen des Anspruchs 8 gelöst. Bezüglich einer Bedien- und Steuervorrichtung wird die genannte Aufgabe mit einer Bedien- und Steuervorrichtung mit den Merkmalen des Anspruchs 10 gelöst. Hinsichtlich eines Montageverfahrens wird die oben genannte Aufgabe durch ein Verfahren mit den Merkmalen des Anspruchs 13 gelöst.

Vorteilhafte Varianten und Ausführungsformen sind Gegenstand der nachfolgenden Beschreibung, der Figurenbeschreibung, der Figuren sowie der Unteransprüche.

Grundsätzlich sollen, insbesondere zur Vermeidung unnötiger Wiederholungen, verfahrensmäßig offenbarte Merkmale auch als vorrichtungsmäßig offenbart gelten, und umgekehrt.

Die Hilfsvorrichtung zur Montage einer Mehrfachanzeigebaugruppe in einer Bedien- und Steuervorrichtung, bevorzugt für eine Werkzeugmaschine, weist erfindungsgemäß einen, bevorzugt plattenförmigen, Grundkörper auf, wobei der Grundkörper eine Vielzahl von Vertiefungen für die Aufnahme von Anzeigeelementen aufweist und wobei der Grundkörper wenigstens zwei Justage-Ausnehmungen, bevorzugt Durchbrüche, aufweist, mit denen der Grundkörper im montierten Zustand an oder in der Bedien- und Steuervorrichtung, insbesondere an Schaltelementen der Bedien- und Steuervorrichtung, ausgerichtet wird.

Dadurch erreicht die Montagehilfsvorrichtung oder Hilfsvorrichtung zur Montage gleichzeitig verschiedene Vorteile. Erstens kann über die Realisierung der Vertiefungen für die Aufnahme der Anzeigeelemente an oder in dem Grundkörper eine reversible Anordnung der Anzeigeelemente in den Vertiefungen realisiert werden, wobei bevorzugt die Befestigung der Anzeigeelemente dann nicht direkt oder unmittelbar an oder in der Bedien- und Steuervorrichtung erfolgt, sondern besonders bevorzugt mittelbar über eine Befestigung des Grundkörpers der Hilfsvorrichtung erreicht wird. Dies erlaubt sowohl bei der Erstmontage als auch bei einer Inspektions- oder Wartungs-Montage oder -Demontage, dass einzelne oder alle Anzeigeelemente selektiv in die Vertiefungen eingesetzt und aus den Vertiefungen entnommen werden können und dementsprechend getauscht werden können.

Vorteilhaft sind die Vertiefungen im Grundkörper in ihrer Abmessung möglichst genau an die Abmessungen oder Außenabmaße der Anzeigeelemente angepasst. Die Anpassung ist bevorzugt in alle drei Raumrichtungen gegeben oder ausgebildet, so dass die Anzeigeelemente möglichst passend in Höhe, Breite und Tiefe in die Vertiefungen eingesetzt werden können und einen möglichst bündigen und/oder lückenlosen Übergang zu dem Grundkörper ermöglichen. In rückseitigen oder verdeckten Bereichen kann durchaus vorteilhaft ein Spiel bestehen oder ausgebildet sein, um die Geometrie der Vertiefungen nicht zu komplex werden zu lassen.

Gegebenenfalls kann besonders vorteilhaft vorgesehen sein, dass die Abmessungen der Vertiefungen so gewählt sind, dass diese minimal kleiner ausfallen als die entsprechenden Abmessungen der Anzeigeelemente, um eine lösbare Klemmhaftung der Anzeigeelemente in den Vertiefungen und damit in oder an dem Grundkörper der Hilfsvorrichtung zu gewährleisten.

Ein weiterer Vorteil oder vorteilhafter Aspekt, der durch die Hilfsvorrichtung gewährleistet wird, resultiert aus dem Zusammenwirken der Vertiefungen zur Aufnahme der Anzeigeelemente einerseits und den Justage-Ausnehmungen, bevorzugt Durchbrüchen, zur Ausrichtung und Anordnung der Hilfsvorrichtung in der Bedien- und Steuervorrichtung, andererseits. Die Vertiefungen können mit einer sehr hohen Präzision maschinell und, falls benötigt, in Großserienfertigung in den Grundkörpern ausgebildet oder zusammen mit der Herstellung der Grundkörper bereitgestellt werden. Gleichermaßen können die Justage-Ausnehmungen, bevorzugt Durchbrüche mit hoher Präzision am oder im Grundkörper der Hilfsvorrichtung ausgebildet werden. Dies führt wiederum dazu, dass der Grundkörper der Hilfsvorrichtung insgesamt eine genaue Positionierung und Ausrichtung der Anzeigeelemente bezüglich der Justage-Ausnehmungen über die Vertiefungen realisiert, was wiederum zu einer genauen Positionierung und Ausrichtung der Anzeigeelemente bezüglich der Bedien- und Steuervorrichtung und damit bezüglich der benachbarten oder ansonsten zugeordneten Schaltelemente führt, wobei besonders vorteilhaft im Rahmen der Montage gerade nicht jedes einzelne Anzeigeelement genau positioniert und ausgerichtet werden muss, sondern durch die Vorpositionierung und Ausrichtung der Anzeigeelemente in den Vertiefungen und damit gegenüber der Justage-Ausnehmungen, lediglich die Justage-Ausnehmungen und damit die Hilfsvorrichtung oder der Grundkörper der Hilfsvorrichtung im Rahmen der Montage positioniert und ausgerichtet werden muss, was wiederum durch die Justage-Ausnehmungen, insbesondere Durchbrüche, besonders erleichtert wird, wie nachfolgend noch weiter erläutert werden wird.

Gemäß einer ersten, vorteilhaften Ausführungsform der Hilfsvorrichtung kann vorgesehen sein, dass sich die Vertiefungen und/oder Justage-Ausnehmungen sich von einer ersten Grundfläche des Grundkörpers in einer Dickenrichtung des Grundkörpers erstrecken. Dies ermöglicht eine einfache und effektive Bearbeitung oder Herstellung des Grundkörpers. Gleichzeitig ermöglicht eine solche Anordnung und Ausbildung der Vertiefungen und der Justage-Ausnehmungen, wenn also sowohl die Vertiefungen als auch die Justage-Ausnehmungen sich von der ersten Grundfläche des Grundkörpers in einer Dickenrichtung erstrecken, dass eine einfache Montage der Hilfsvorrichtung in oder an der Bedien- oder Steuervorrichtung im Sinne eines Einsteck- oder Einschubvorgangs, bevorzugt von rückwärtig auf ein Frontelement zu gerichtet, erreicht werden kann.

Gemäß einer weiteren, besonders vorteilhaften Variante der Hilfsvorrichtung kann vorgesehen sein, dass diese eine Vielzahl von Dichtrahmen aufweist, wobei die Anzahl der Dichtrahmen bevorzugt der Anzahl der Vertiefungen für die Aufnahme von Anzeigeelementen entspricht und wobei die Dichtrahmen jeweils umlaufend und geschlossen um die Vertiefungen angeordnet sind. Dadurch kann eine Dichtheit, insbesondere eine Staubdichtheit, der Anzeigeelemente innerhalb der Bedien- und Steuervorrichtung sichergestellt werden. Weiterhin kann durch Dichtrahmen mit einem gewissen Anteil an plastischer oder elastischer Verformbarkeit ein geringfügiges oder minimales Ausgleichsspiel in Dickenrichtung des Grundkörpers für die Montage bereitgestellt werden, sodass wenn beispielsweise im Rahmen der Montage die Hilfsvorrichtung bei der Befestigung in der Bedien- und Steuervorrichtung der Grundkörper entlang der Dickenrichtung auf ein Frontelement, insbesondere eine Frontscheibe, zu Kraft beaufschlagt wird, die Kräfte zunächst durch eine Verformung und/oder ein Anpressen der Dichtrahmen an das Frontelement aufgenommen oder zumindest teilweise aufgenommen werden können.

In einer weiteren, besonders wünschenswerten Ausgestaltung der Hilfsvorrichtung kann vorgesehen sein, dass die Vertiefungen mit angrenzenden Anschlusskanälen zur Führung von Kabeln der Anzeigeeinheit verbunden sind. Mit anderen Worten ausgedrückt bedeutet dies, dass in der vorteilhaften Ausführungsform im Grundkörper der Hilfsvorrichtung Anschlusskanäle ausgebildet sind, die an die Vertiefungen zur Aufnahme von Anzeigeelementen angrenzen und die Führung von Kabeln der Anzeigeelemente ermöglichen. Die Anschlusskanäle können bevorzugt als Durchbrüche vorgesehen sein und von der ersten Grundfläche und/oder von einer Seite oder dem Boden der Vertiefungen bis zu einer zweiten, in Dickenrichtung der ersten Grundfläche gegenüberliegenden Grundfläche ausgebildet sein. Die Anordnung und der Verlauf der Anschlusskanäle kann bevorzugt von der Art, der Verbindung und der Orientierung der mit der Anzeigeelemente verbundenen Anschlusskabeln abhängig gestaltet oder ausgeführt werden. Dadurch kann erreicht werden, dass die Kabel auf der ersten Grundfläche oder an der ersten Grundfläche nicht über diese herausstehen oder in Dickenrichtung hervorragen, was wiederum die unmittelbare, lediglich durch eventuell vorzusehende Dichtrahmen beabstandete Anordnung des Grundkörpers der Hilfsvorrichtung an einem Frontelement der Bedien- und Steuervorrichtung erlaubt. Gleichzeitig kann dadurch eine platzsparende Ausbildung der Hilfsvorrichtung realisiert werden, wenn nämlich weitere, gegebenenfalls notwendige Infrastruktur, wie auch nachfolgend noch im Detail beschrieben, auf der Rückseite oder der zweiten Grundfläche des Grundkörpers angeordnet wird, die dann über entsprechende Kabel oder Anschlusskabel mit den Anzeigeelementen verbunden wird.

Weiterhin kann in einer vorteilhaften Ausführungsvariante der Hilfsvorrichtung vorgesehen sein, dass auf einer zweiten Grundfläche des Grundkörpers der Hilfsvorrichtung, bevorzugt in Verlängerung der Vertiefungen in Dickenrichtung, besonders bevorzugt angrenzend an Anschlusskanäle, elektronische Kontaktmittel, bevorzugt in der Form von bedruckten Leiterplatten (printed circuit boards: PCB) angeordnet sind. Die Kontaktmittel können zur Kontaktierung von Kabeln der Anzeigeelemente dienen, welche bevorzugt durch die Anschlusskanäle ausgehend von den Vertiefungen auf die Rückseite oder zweite Grundfläche des Grundkörpers geführt werden. Neben den Kontaktmitteln, in Form von mit Steckern oder Steckvorrichtungen bestückten Leiterplatten, können auch weitere elektronische oder elektrische Komponenten zusammen mit den Kontaktmitteln auf entsprechenden Leiterplatten vorgesehen sein. Dadurch kann bevorzugt das Kontaktmittel zu einem Kontakt- und Steuermittel auf der Grundlage einer bedruckten Leiterplatte weitergebildet werden, die dann nicht nur den Anschluss der Anzeigeelemente, sondern teilweise auch die Steuerung der Anzeigeelemente bewirkt oder zumindest mitbewirkt.

Gemäß einer ebenfalls vorteilhaften Ausführungsform der Hilfsvorrichtung kann zudem vorgesehen sein, dass die Anzahl der Vertiefungen der Anzahl der Justage-Ausnehmungen entspricht. Wie oben oder eingangs bereits beschrieben, dienen die Anzeigeelemente der Beschriftung oder der graphischen Betitelung oder Beschreibung des mit dem benachbarten oder zugeordneten Schaltelements zu schaltenden oder einzustellenden Zustands, wobei die Schaltelemente als physische oder physikalische Schalter realisiert sind. Da die Position und Anordnung der Schaltelemente wiederum eine oder sogar die maßgebliche Vorgabe für die Positionierung der Anzeigeelemente darstellt, ist es von besonderem Vorteil für eine einfache, effektive und trotzdem genaue Montage der Anzeigeelemente, wenn die Schaltelemente selber oder ein Teil der Schaltelemente oder eine Oberfläche oder eine Kontur der Schaltelemente die Ausrichtung der Anzeigeelemente, bevorzugt über die Ausrichtung und Justage-Ausnehmungen des Grundkörpers der Hilfsvorrichtung verursachen. Denn dadurch können verschiedene Vorteile erreicht werden. Einerseits kann durch den Abgleich zwischen Schaltelementen und Justage-Ausnehmungen sichergestellt werden, dass die Schaltelemente präzise und gemäß den Vorgaben in der Bedien- und Steuervorrichtung angeordnet sind, da sonst nicht alle Justage-Ausnehmungen mit den Schaltelementen ausgerichtet oder ansonsten in räumliche Übereinstimmung gebracht werden können. Gleichzeitig wird dadurch sichergestellt, dass die Anzeigeelemente präzise gegenüber den Schaltelementen ausgerichtet und angeordnet sind. Schließlich wird auch erreicht, dass zusätzlich zu den Schaltelementen keine weiteren Justagemittel, wie beispielsweise Justage-Stifte, Vorsprünge oder dergleichen auf Seiten der Bedien- und Steuervorrichtung vorgesehen werden müssen, sondern dass die Schaltelemente selbst oder zumindest Teile der Schaltelemente selbst zur Ausrichtung der Hilfsvorrichtung über die Justage-Ausnehmungen dienen.

Weiterhin kann in einer besonders wünschenswerten Ausprägung der Hilfsvorrichtung vorgesehen sein, dass die Vertiefungen nebeneinander in einer Reihe und bevorzugt parallel zueinander angeordnet sind und die Justage-Ausnehmungen in einer Reihe neben den Vertiefungen, bevorzugt an den Vertiefungen ausgerichtet, angeordnet sind. Diese Beziehung zwischen Justage-Ausnehmung und Vertiefungen sorgt in einer besonders vorteilhaften Art und Weise für eine mögliche Ausrichtung und Justage der Hilfsvorrichtung an oder über die Schaltelemente, die, wie oben bereits angedeutet, bevorzugt jeweils neben den Anzeigeelementen angeordnet sind oder angeordnet werden.

Die oben genannte Aufgabe wird auch durch eine Mehrfachanzeigebaugruppe mit einer Hilfsvorrichtung gemäß der vorangehend beschriebenen Ausführungsformen gelöst, wobei in den Vertiefungen jeweils ein Anzeigeelement angeordnet ist. Die Anzeigeelemente sind dabei bevorzugt so in den Vertiefungen angeordnet, dass eine Darstellungsfläche oder Bildfläche der Anzeigeelemente im Wesentlichen parallel oder plan-parallel zur ersten und/oder zweiten Grundfläche des Grundkörpers angeordnet ist und vom Grundkörper wegorientiert ist, sodass die Anzeigeinhalte von außen sichtbar sind. Als Anzeigeelemente kommen grundsätzlich verschiedenste Technologien infrage. Neben Anzeigeelementen auf der Basis von LCD- oder LED- sowie OLED-Technologie, können auch Anzeigeelemente als Paper-Ink-Displays ausgeführt sein. Auch weitere Anzeige- oder Display-Technologien können zum Einsatz kommen.

Die Mehrfachanzeigebaugruppe kann besonders vorteilhaft so ausgestaltet sein, dass die Anzeigeelemente in den Vertiefungen entnehmbar oder reversibel angeordnet sind. Die kann besonders bevorzugt über eine Klemmwirkung der Anzeigeelemente in der Vertiefungen erreicht werden. Alternativ kann auch vorgesehen sein, dass die Anzeigeelemente über einen lösbaren Haftvermittler am Boden der Vertiefungen reversibel befestigt, insbesondere verklebt sind. Beispielsweise kann ein doppelseitiges Klebeband am Boden der Vertiefungen angeordnet werden, dass dann einerseits mit dem Anzeigeelement und andererseits mit der Vertiefung oder dem Grundkörper verklebt wird oder verklebt ist.

Die Mehrfachanzeigebaugruppe kann damit leicht vormontiert und im Rahmen der Erstmontage in der Bedien- und Steuervorrichtung montiert werden. Außerdem kann die Mehrfachanzeigebaugruppe leicht aus einer entsprechenden Bedien- und Steuervorrichtung entnommen oder ausgebaut werden, beispielsweise um einzelne defekte Anzeigeelemente zu tauschen oder zu ersetzen.

Gemäß einer vorteilhaften Variante der Mehrfachanzeigebaugruppe kann vorgesehen sein, dass die Anzeigeelemente mit Kabeln, bevorzugt mit einem Flachkabel, durch Anschlusskanäle in der Hilfsvorrichtung, bevorzugt dem Grundkörper der Hilfsvorrichtung, mit elektronischen Kontaktmitteln verbunden sind. Dabei kann, wie oben bereits beschrieben, vorgesehen sein, dass sich die Anschlusskanäle ausgehend von den Vertiefungen und/oder der ersten Grundfläche des Grundkörpers als Durchbrüche bis zu einer zweiten Grundfläche des Grundkörpers erstrecken an oder auf der die Kontaktmittel angeordnet sind. Die Verwendung von Anzeigeelementen mit einem einzigen, bevorzugt als Flachkabel ausgeführten Kabel erleichtert dabei die Montage oder Vormontage der Mehrfachanzeigebaugruppe. Beispielsweise kann in einfachen Schritten zunächst das Flachkabel durch den Anschlusskanal auf die Rückseite oder zweite Grundfläche des Grundkörpers der Hilfsvorrichtung geführt und dort mit den Kontaktmitteln verbunden werden, bevor dann auf der ersten Grundfläche die Anzeigeelemente in die Vertiefungen eingesetzt und gegebenenfalls dort befestigt oder lösbar arretiert werden.

Die eingangs formulierte Aufgabe wird auch mit einer Bedien- und Steuervorrichtung, bevorzugt für eine Werkzeugmaschine gelöst, wobei die Bedien- und Steuervorrichtung ein Frontelement, bevorzugt eine Frontscheibe, und ein an das Frontelement angrenzenden Rahmen aufweist, wobei in Ausnehmungen des Frontelements eine Vielzahl von Schaltelementen angeordnet oder teilweise aufgenommen sind. Erfindungsgemäß ist dabei vorgesehen, dass im inneren des Rahmens, bevorzugt hinter dem Frontelement, eine Mehrfachanzeigebaugruppe gemäß einer der vorangehenden Ausführungsformen oder eine Hilfsvorrichtung gemäß einer der vorangehend beschriebenen Ausführungen angeordnet ist, wobei die Justage-Ausnehmungen an nach innen in den Rahmen vorstehenden Konturen von Schaltelementen ausgerichtet sind.

Dadurch wird ermöglicht, dass die Anzeigeelemente schnell, sicher und genau während des Montagevorgangs angeordnet und ausgerichtet werden können. Gleichzeitig wird dadurch ermöglicht, dass alle Anzeigeelemente gleichzeitig montiert und ausgerichtet werden können. Ferner wird ermöglicht, dass, bei Bedarf, über eine Demontage der Mehrfachanzeigebaugruppe oder der Hilfsvorrichtung einzelne Anzeigeelemente getauscht und die Gesamtheit der Anzeigeelemente nach dem Tausch wieder montiert werden können, ohne dass dadurch die Präzision der Anordnung und Ausrichtung eines oder aller Anzeigeelemente nachteilig beeinflusst wird. Auch die erneute Montage nach einem Tausch eines Anzeigeelements kann besonders schnell und einfach erfolgen, und zwar in gleichem Maße wie eine Erstmontage.

Wie oben bereits angedeutet ist es besonders vorteilhaft, wenn die in dem Frontelement oder durch Ausnehmungen im Frontelement nach innen vorstehenden Schaltelemente, bevorzugt in der Form von physischen oder physikalischen Schaltern, ganz oder zum Teil zur Ausrichtung der Justage-Ausnehmung dienen. Dadurch entfallen nicht nur zusätzliche Justage-Elemente an dem Frontelement oder am Rahmen. Es wird dadurch auch sichergestellt, dass sowohl die Anordnung und Ausrichtung der Schaltelemente korrekt und einwandfrei ist und weiterhin die Relativanordnung zwischen Schaltelementen und Anzeigeelementen den gewünschten Vorgaben und der notwendigen Präzision entsprechen.

In einer weiteren, besonders wünschenswerten Ausgestaltung umfassen die Schaltelemente an den nach innen in den Rahmen vorstehenden Konturen Sicherungsmittel, bevorzugt zur Befestigung der Schaltelemente an einer Aufnahmeeinrichtung, besonders bevorzugt dem Frontelement, wobei der Grundkörper der Hilfsvorrichtung über mit den Sicherungsmitteln zusammenwirkenden Befestigungsmitteln an den Schaltelementen und damit in der Bedien- und Steuervorrichtung befestigt ist. In einer besonders bevorzugten Ausgestaltung kann vorgesehen sein, dass die nach innen in den Rahmen vorstehenden Konturen der Schaltelemente ein Außengewinde, bevorzugt zur Befestigung der Schaltelemente an dem Frontelement aufweisen, und der Grundkörper der Hilfsvorrichtung über Muttern mit einem entsprechenden Innengewinde, die auf das Außenwinde aufgeschraubt sind, in der Bedien- und Steuervorrichtung befestigt ist.

Es ist durchaus üblich, dass Schaltelemente in Form von physikalischen Schaltern entsprechende Befestigungs- und Sicherungsmittel ausbilden oder umfassen. Im Sinne der vorliegenden Erfindung können diese besonders vorteilhaft zu mehreren Zwecken gleichzeitig genutzt werden. Denn beispielsweise besteht die Möglichkeit die Schaltelemente nur lose in das Frontelement, insbesondere in die Frontscheibe, einzusetzen und dann über Muttern oder sonstige Befestigungsmittel, die innenliegend hinter dem Grundkörper der Hilfsvorrichtung angeordnet werden, zusammen mit der Hilfsvorrichtung und/oder der Mehrfachanzeigebaugruppe in der Bedien- und Steuervorrichtung zu fixieren oder zu arretieren. Dadurch wird eine besonders einfache effektive Montage sowie die Minimierung von Bauteilen erreicht. In diesem Fall führt eine Entfernung der Hilfsvorrichtung oder der Mehrfachanzeigebaugruppe aber auch zu einem lösen der Schaltelemente in oder gegenüber dem Frontelement.

Alternativ und ebenfalls vorteilhaft kann vorgesehen sein, dass über die vorgesehenen Befestigungsmittel, beispielsweise Außengewinde, und dazugehörige Sicherungsmittel, insbesondere Schraubmuttern, zunächst die Schaltelemente an dem Frontelement befestigt oder verschraubt werden und dann an den befestigten Schaltelementen der Grundkörper der Hilfsvorrichtung befestigt wird, wobei abermals entsprechende Schraubmuttern an den Außengewinden der Schaltelemente angeschraubt oder aufgeschraubt werden, bis der Grundkörper der Hilfsvorrichtung auf dem Frontelement aufliegt oder zumindest die Dichtrahmen der Hilfsvorrichtung von innen an das Frontelement gepresst werden. Dies erfordert zwar mehr einzelne Bauteile, insbesondere in Form der zusätzlichen Schraubmuttern, ermöglicht aber auch, dass die Schaltelemente in der Bedien- und Steuervorrichtung gesichert oder befestigt bleiben, wenn die Hilfsvorrichtung oder die Mehrfachanzeigebaugruppe entfernt oder entnommen wird.

Die eingangs formulierte Aufgabe wird auch durch ein Verfahren zur Montage einer Vielzahl von Anzeigeelementen in einer Bedien- und Steuervorrichtung, insbesondere für eine Werkzeugmaschine, mit den nachfolgenden Verfahrensschritten gelöst: Einfügen einer Vielzahl von Anzeigeelementen in Vertiefungen eines Grundkörpers einer Hilfsvorrichtung, insbesondere einschließlich elektronischer Kontaktierung an Kontaktmitteln der Hilfsvorrichtung über Anschlusskanäle des Grundkörpers. Ausrichten und Anordnen der Hilfseinrichtung in der Bedien- und Steuervorrichtung, in dem Justage-Ausnehmungen im Grundkörper der Hilfsvorrichtung an von einem Frontelement nach innen in das Innere eines Rahmen der Bedien- und Steuervorrichtung vorstehenden Konturen von Schaltelementen der Bedien- und Steuervorrichtung ausgerichtet werden. Befestigen der Hilfsvorrichtung in der Bedien- und Steuervorrichtung, insbesondere über eine Befestigung des Grundkörpers an den nach innen vorstehenden Konturen von Schaltelementen.

Wie vorangehend an verschiedenen Stellen der Beschreibung bereits ausgeführt, kann über die Hilfsvorrichtung sowie über die zwischenzeitliche Herstellung oder Montage einer Mehrfachanzeigebaugruppe eine einfache, schnelle und präzise Ausrichtung und Montage der Anzeigeelemente sowie der nachträgliche Austausch einzelner Anzeigeelemente sichergestellt werden, wobei bevorzugt Teile der Bedien- und Steuervorrichtung selbst, insbesondere Teile der Schaltelemente zur Justage und Ausrichtung der Hilfsvorrichtung und/oder zur Befestigung der Hilfsvorrichtung und damit zur Ausrichtung der Anzeigeelemente und zur Befestigung der Anzeigeelemente genutzt oder mitgenutzt werden.

Gemäß einer weiteren vorteilhaften Variante des Verfahrens kann vorgesehen sein, dass bei der Ausrichtung und Anordnung der Hilfsvorrichtung die nach innen in den Rahmen vorstehenden Konturen der Schaltelemente zumindest teilweise durch die Justage-Ausnehmungen, insbesondere Durchbrüche, in dem Grundkörper der Hilfsvorrichtung geführt werden. Dies ermöglicht in besonders vorteilhafter Weise eine Befestigung, insbesondere ein Verschrauben der Hilfsvorrichtung von der Rückseite oder einer zweiten Grundfläche des Grundkörpers der Hilfsvorrichtung, sodass dadurch nicht nur die Justage, sondern auch die Befestigung und Kraftbeaufschlagung, insbesondere Anpressung, in Dickenrichtung des Grundkörpers der Hilfsvorrichtung auf oder an das Frontelement der Bedien- und Steuervorrichtung gewährleistet werden kann.

Gemäß einer weiteren besonders wünschenswerten Ausgestaltung des Verfahrens kann vorgesehen sein, dass beim Befestigen der Hilfsvorrichtung in der Bedien- und Steuervorrichtung der Grundkörper der Hilfsvorrichtung mit Muttern befestigt wird, die auf Außengewinden aufgeschraubt werden, die auf den nach innen in den Rahmen vorstehenden Konturen der Schaltelemente angeordnet sind und die bevorzugt zur Befestigung der Schaltelemente an dem Frontelement dienen. Durch diese Verfahrensführung wird ein besonders einfaches Ausrichten und Befestigen der Anzeigeelemente in der Bedien- und Steuervorrichtung ermöglicht.

Nachfolgend werden Ausführungsformen, vorteilhafte Wirkungen und Details der erfindungsgemäßen Vorrichtungen und des erfindungsgemäßen Verfahrens anhand von rein schematischen, Ausführungsbeispiele der Erfindung darstellenden Zeichnungen veranschaulicht und beschrieben. Darin zeigen:
- Fig. 1a:: eine Draufsicht auf eine erste Grundfläche einer erfindungsgemäßen Hilfsvorrichtung sowie einer erfindungsgemäßen Mehrfachanzeigebaugruppe;
- Fig. 1b:: eine Draufsicht auf eine zweite Grundfläche einer erfindungsgemäßen Hilfsvorrichtung und einer erfindungsgemäßen Mehrfachanzeigebaugruppe;
- Fig. 2:: eine perspektivische Schnittdarstellung durch eine erfindungsgemäße Bedien- und Steuervorrichtung;
- Fig. 3:: eine Seitenansicht einer erfindungsgemäßen Hilfsvorrichtung sowie einer erfindungsgemäßen Mehrfachanzeigebaugruppe einschließlich entsprechender Schaltelemente.

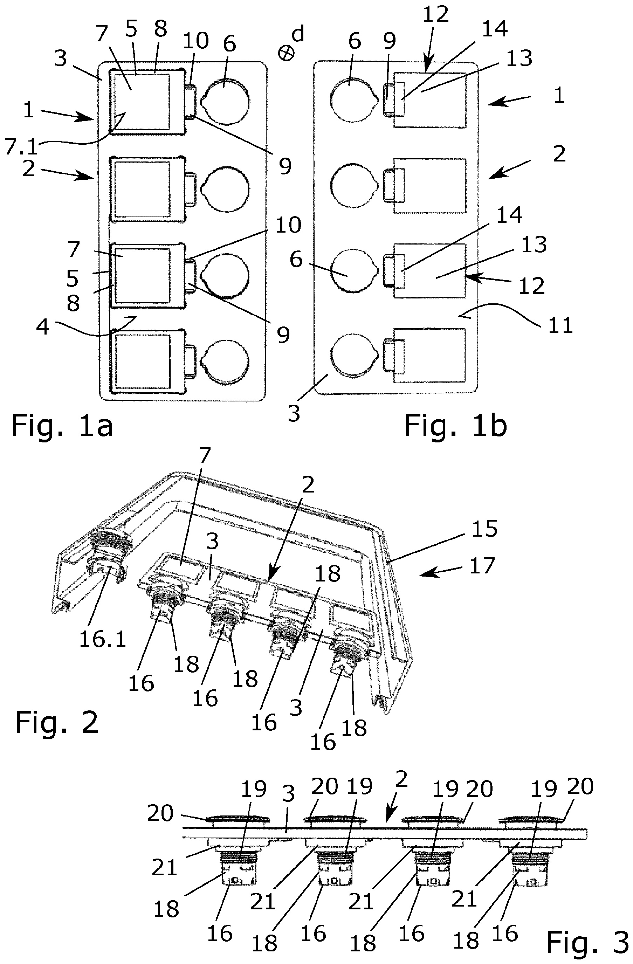

Fig. 1a zeigt eine Draufsicht auf eine erfindungsgemäße Hilfsvorrichtung 1 und eine aus der erfindungsgemäßen Hilfsvorrichtung 1 hervorgehende, ebenfalls erfindungsgemäße Mehrfachanzeigenbaugruppe 2. Die erfindungsgemäße Hilfsvorrichtung 1 umfasst einen plattenförmigen Grundkörper 3 mit einer ersten Grundfläche 4. In der ersten Grundfläche 4 angeordnet oder von der ersten Grundfläche 4 ausgehend erstrecken sich in Dickenrichtung d, senkrecht auf der Zeichenebene der Fig. 1a und Fig. 1b Vertiefungen 5 und Justage-Ausnehmungen 6. Die Justage-Ausnehmungen 6 sind als Durchbrüche ausgeführt und erstrecken sich über die gesamte Dicke in Dickenrichtung d des Grundkörpers 3. Die Vertiefungen 5 erstrecken sich in Dickenrichtung d nur über einen Teil der Dicke des Grundkörpers 3. In die Vertiefungen 5 eingesetzt und bevorzugt in den Vertiefungen 5 reversibel befestigt, beispielsweise über doppelseitiges Klebeband, welches in der Fig. 1a/b nichtdargestellt ist, sind Anzeigeelemente 7 angeordnet.

Die Anzeigeelemente 7 werden von auf der ersten Grundfläche 4 angeordneten, bevorzugt aus Schaumgummi oder Schaumstoff gefertigten, um die Vertiefungen 5 umlaufend angeordneten Dichtrahmen 8 umschlossen. Ansonsten verlaufen die Anzeigeelemente 7 mit einer Oberfläche 7.1 bevorzugt im wesentlichen plan-parallel zur ersten Grundfläche 4. Die Dichtrahmen 8 stehen bevorzugt geringfügig in Dickenrichtung d über die erste Grundfläche 4 des Grundkörpers 3 über. Die Anzeigeelemente 7 der Mehrfachanzeigebaugruppe 2 weisen seitlich angeordnete Kabel, insbesondere ein seitlich angeordnetes Flachkabel 9 auf. Das Flachkabel 9 verläuft jeweils ausgehend vom Anzeigeelement 7 durch einen angrenzend an die Vertiefung 5 im Grundkörper 3 der Hilfsvorrichtung 1 ausgebildeten Anschlusskanal 10. Der Anschlusskanal 10 erstreckt sich in Dickenrichtung d bis auf eine zweite Grundfläche des Grundkörpers 3 der Hilfsvorrichtung 1.

Die Fig. 1b zeigt einen Blick auf die zweite Grundfläche 11 des Grundkörpers 3 der Hilfsvorrichtung 1. Damit zeigt die Fig. 1b die Rückansicht zur Darstellung der Fig. 1a im Hinblick auf die Hilfsvorrichtung 1 und die Mehrfachanzeigebaugruppe 2. Erkennbar ist, dass die Justage-Ausnehmungen 6, die als Durchbrüche durch den Grundkörper 3 in Dickenrichtung d ausgebildet sind bis auf die zweite Grundfläche 11 des Grundkörpers reichen oder führen. Gleichermaßen ist erkennbar, dass auf der zweiten Grundfläche 11 angeordnete Kontaktmittel 12 dazu genutzt werden, um das im Anschlusskanal 10 auf die zweite Grundfläche 11 geführte Flachkabel 9 zu kontaktieren. Die Kontaktmittel 12 können eine gedruckte Leiterplatte 13 sowie einen Stecker 14 oder eine Steckeraufnahme und gegebenenfalls weitere elektrische oder elektronische Komponenten zur Bedienung und Steuerung der Anzeigeelemente 7 aufweisen.

Anhand der Darstellung der Fig. 1a und Fig. 1b wird erkennbar, dass in dem Grundkörper 3 der Hilfsvorrichtung 1 die Anzeigeelemente 7 durch ihre Anordnung in den Vertiefungen 5 eine wohldefinierte Anordnung untereinander sowie eine wohldefinierte Anordnung gegenüber den Justage-Ausnehmungen 6 aufweisen. Weiterhin ist erkennbar, dass eine gleiche Anzahl an Vertiefungen 5 wie Justage-Ausnehmungen 6 vorliegt oder ausgebildet ist. Weiterhin sind die Justage-Ausnehmungen 6 sowie auch die Vertiefungen 5 beide als Reihen ausgebildet, die untereinander und zueinander benachbart ausgebildet oder angeordnet sind. Es lässt sich bereits in den Fig. 1a und 1b gut erkennen, dass die Vormontage der Anzeigeelemente 7 in den Vertiefungen 5 und deren Anschluss oder Kontaktierung an den Kontaktmitteln 12 über die Anschlusskanäle 10 schnell und leicht vonstattengeht und gleichzeitig, insbesondere bei einer reversiblen Befestigung oder reversiblen Anordnung der Anzeigeelemente 7 in den Ausnehmungen 5 dazu führt, dass einzelne Anzeigeelemente zu einem späteren Zeitpunkt auch einfach ausgetauscht oder gewechselt werden können. Die besonders vorteilhafte Wirkung der Justage-Ausnehmungen 6, insbesondere im Zusammenspiel mit Schaltelementen, insbesondere physikalischen Schaltern, wird mit Bezug auf die Fig. 2 und 3 noch deutlicher. Es lässt sich jedoch bereits erkennen, dass bei einem Aufbringen des Grundkörpers 3 der Hilfsvorrichtung 1 über entsprechende Justagemittel auf Seiten einer Steuer- und Bedienvorrichtung die Justage-Ausnehmungen 6 dazu führen, dass die Anzeigeelemente 7 in einer genau definierten Position und einer ebenfalls genau definierten Ausrichtung in oder an der Bedien- und Steuervorrichtung positioniert werden können.

Die Fig. 2 zeigt einen Schnitt durch eine perspektivische Darstellung einer erfindungsgemäßen Bedien- und Steuervorrichtung. Die grundsätzliche Ausgestaltung der Bedien- und Steuervorrichtung kann beispielsweise in Übereinstimmung mit der Offenbarung der DE 10 2018 124 087 A1 und insbesondere der dort dargestellten Fig. 2 erfolgen.

Besonders bevorzugt ist die Bedien- und Steuervorrichtung 17 zur Steuerung und Bedienung einer Werkzeugmaschine vorgesehen. Die Bedien- und Steuervorrichtung 17 weist einen Rahmen 15 auf, an dem auf einer Seite ein Frontelement, insbesondere eine Frontscheibe angeordnet ist. Das Frontelement ist aus Gründen der Übersichtlichkeit in der Darstellung der Fig. 2 nicht dargestellt. Im Frontelement sind dabei bevorzugt Ausnehmungen angeordnet, durch die oder mit denen Schaltelemente 16, bevorzugt in der Form von physikalischen Schaltern, von Seiten des Frontelements zugänglich und bedienbar sind. Neben den Schaltelementen 16 sind zur Anzeige, Verdeutlichung oder Beschriftung der veränderbaren Funktion oder Funktionalität der Schaltelemente 16 die eine Vielzahl von Anzeigeelementen 7 angeordnet werden, die veränderbare Inhalte anzeigen können, um die veränderbare oder veränderliche Funktionalität der Schaltelemente 16 wiedergeben zu können.

Die Bedien- und Steuervorrichtung 17 kann zudem weitere Komponenten, bevorzugt auch eine berührungsempfindliche, optische Ein- und Ausgabeschnittstelle aufweisen, die in der Darstellung der Fig. 2 aus Gründen der Übersichtlichkeit jedoch nicht dargestellt sind. In der Fig. 2 ist ein weiteres Schaltelement 16.1 dargestellt, das als physischer oder physikalischer NotausSchalter dient. Das Schaltelement 16.1 weist in der Bedienung der Bedien- und Steuervorrichtung 17 in unterschiedlichen Steuer- oder Betriebsmodi keine unterschiedliche oder veränderbare Funktion auf. Deshalb ist auch kein anpassbarer oder veränderbarer Anzeigeinhalt zur Anzeige der jeweiligen oder jeweils aktuellen Funktionalität des Schaltelements 16.1 erforderlich. Stattdessen kann das Schaltelement 16.1 klassisch beschriftet oder bezeichnet werden, beispielsweise durch einen Aufdruck oder eine Beschriftung auf dem nicht dargestellten Frontelement. Daraus folgt auch, dass in einer vorteilhaften Ausführungsform der Erfindung die Anzahl der in ihrer Funktion oder Funktionalität veränderbaren Schaltelemente 16 mit der Anzahl der Anzeigeelemente 7 übereinstimmt. Ferner ist dementsprechend gemäß einer weiterhin vorteilhaften Ausführungsform vorgesehen, dass die Anzahl der Justage-Ausnehmungen 6 mit der Anzahl der Schaltelemente 16 übereinstimmt, deren Funktion oder Funktionalität je nach Betriebs- oder Bedienmodus verändert werden kann.

Im Beispiel der Fig. 2 sind vier Schaltelemente 16 vorgesehen, die je nach Bedienmodus oder Betriebsmodus der Bedien- und Steuervorrichtung 17 eine andere Funktion aufweisen sollen oder eine andere Funktionalität der zu steuernden Vorrichtung, insbesondere der Werkzeugmaschine steuern sollen. Dementsprechend ist, wie in der Fig. 1a und Fig. 1b bereits angedeutet eine Hilfsvorrichtung 1 sowie eine auf der Hilfsvorrichtung 1 basierende Mehrfachanzeigebaugruppe 2 vorgesehen, die ebenfalls vier Anzeigeelemente 7 aufweist.

In der Fig. 2 ist bereits erkennbar, dass die Schaltelemente 16 von der nicht dargestellten Frontscheibe oder dem nicht dargestellten Frontelement ausgehende, nach innen in den Rahmen 15 vorstehende Konturen 18 aufweisen, wobei diese Konturen 18 genützt werden, um den Grundkörper 3 der Hilfsvorrichtung 1 über die Justage-Ausnehmungen 6 auszurichten und zu befestigen. Dadurch wird erreicht, dass die Anzeigeeinheiten 7 eine genaue Ausrichtung und Anordnung gegenüber den Schaltelementen 16 aufweisen und zudem einzelne Anzeigeelemente 7, auch nachträglich, noch getauscht werden können, in dem lediglich die Mehrfachanzeigebaugruppe 2 wieder gelöst oder entfernt werden muss, um Zugriff zu den Anzeigeelementen 7 zu erhalten.

Die Fig. 3 zeigt in der Seitenansicht nochmals im Detail die Art und Weise, wie die Mehrfachanzeigebaugruppe 2 und die Hilfsvorrichtung 1 an den Schaltelementen 16 ausgerichtet und befestigt wird. Die Schaltelemente 16 weisen an den nach innen in den Rahmen 15 vorstehenden Konturen 18 Außengewinde 19 auf, die in der Regel dazu dienen die Schaltelemente 16 an einem Grundpanel oder einer Grundfläche zu befestigen. Dazu weisen die Schaltelemente 16 auf der einen Seite einen Kragen 20 zum Abstützen am Grundpanel auf. Wird eine Mutter oder Schraubmutter 21 rückseitig auf die Kontur 18 und das Außengewinde 19 aufgeschraubt, entsteht ab einem Unterschreiten eines Abstands in der Größenordnung der Stärke des Grundpanels eine Klemmspannung zwischen Kragen 20 und Mutter 21.

Diese Funktionalität der Schaltelemente 16 wird in besonders vorteilhafterweise im Rahmen der Erfindung auch genutzt, um die Anzeigeelemente auszurichten und zu befestigen. Denn die nach innen vorstehenden Konturen 18 der Schaltelemente 16 werden durch die Justage-Ausnehmungen 6 geführt, wodurch die Ausrichtung und Anordnung der Anzeigeelemente vorgegeben wird. Durch ein rückseitiges oder rückwärtiges Aufbringen entsprechender Schraubmuttern 21 mit Innengewinde, kann eine Verschraubung des Grundkörpers 3 der Hilfsvorrichtung 1 in der Bedien- und Steuervorrichtung 17 mittelbar über die Schaltelemente 16 erfolgen. In der Fig. 3 ist zwischen dem Kragen 20 der Schaltelemente 16 und dem Grundkörper 3 der Hilfsvorrichtung 1 oder der Mehrfachanzeigebaugruppe 2 ein Abstand ausgebildet. Dieser wird durch die Stärke oder Dicke eines Frontelements, insbesondere einer Frontscheibe beansprucht, die aus Gründen der Übersichtlichkeit in der Fig. 3 nicht dargestellt ist. Somit ist erkennbar, dass die Schraubmuttern 21 nicht nur den Grundkörper 3 der Hilfsvorrichtung 1 rückwärtig an die nicht dargestellte Frontscheibe anpressen, sobald eine entsprechende Klemmwirkung der Muttern 21 gewährleistet ist, sondern dass auch die grundsätzliche Befestigung der Schaltelemente 16 in der Bedien- und Steuervorrichtung, insbesondere am Frontelement, über die besagten Muttern 21 gewährleistet wird.

Mit anderen Worten ausgedrückt bedeutet dies, dass zur Ausrichtung der Anzeigeelemente 7 in der Bedien- und Steuervorrichtung 17 lediglich die Justage-Ausnehmungen 6 über die nach innen vorstehenden Konturen 18 der Schaltelemente 16 geführt werden müssen, wobei die Schaltelemente 16 ansonsten nur lose durch Ausnehmungen im Frontelement geführt sind oder geführt werden. Zum Montieren und Demontieren der Anzeigeelemente 7 sowie zur Befestigung der Anzeigeelemente 7 und zur Befestigung der Schaltelemente 16 müssen anschließend lediglich die Muttern 21 auf die Außengewinde 19 der nach innen vorstehenden Konturen 18 geschraubt und gegebenenfalls über entsprechende Sicherungsmittel gesichert oder gegen ein Lösen gesichert werden.

Allein durch das Befestigen der Muttern 21 wird dadurch die korrekte und passgenaue endgültige Ausrichtung der Anzeigeelemente 7 gegenüber dem Frontelement, insbesondere der Frontscheibe, und dort vorgesehenen Masken oder Maskierungen erreicht.

Die Mehrfachanzeigebaugruppe 2 kann bevorzugt zentral und einheitlich über eine entsprechende Schnittstelle, bevorzugt angeschlossen oder verbunden über entsprechende Steckverbinder, mit dem Rest der Steuer- und Bedienvorrichtung verbunden, verschaltet und versorgt werden. Diesbezügliche Details sind in den Fig. 1 bis 3 nicht dargestellt.

### Bezugszeichenliste

- 1: Hilfsvorrichtung
- 2: Mehrfachanzeigebaugruppe
- 3: Grundkörper
- 4: 1.Grundfläche
- 5: Vertiefungen
- 6: Justage-Ausnehmungen
- 7: Anzeigeelemente
- 8: Dichtrahmen
- 9: Flachkabel
- 10: Anschlusskanal
- 11: 2.Grundfläche
- 12: Kontaktmittel
- 13: Leiterplatte
- 14: Stecker
- 15: Rahmen
- 16: Schaltelement
- 16.1: Schaltelement
- 17: Bedien- und Steuervorrichtung
- 18: Konturen
- 19: Außengewinde
- 20: Kragen
- 21: Schraubmutter
- d: Dickenrichtung

## Patentansprüche

1. Hilfsvorrichtung **(1)** zur Montage einer Mehrfachanzeigebaugruppe **(2)** in einer Bedien- und Steuervorrichtung **(17),** bevorzugt für eine Werkzeugmaschine,
**gekennzeichnet durch**
einen, bevorzugt plattenförmigen, Grundkörper **(3),** wobei der Grundkörper **(3)** eine Vielzahl von Vertiefungen **(5)** für die Aufnahme von Anzeigeelementen **(7)** aufweist und der Grundkörper **(3)** wenigstens zwei Justage-Ausnehmungen **(6),** bevorzugt Durchbrüche, aufweist, mit denen der Grundkörper **(3)** im montierten Zustand an oder in der Bedien- und Steuervorrichtung **(17),** insbesondere an Schaltelementen **(16)** der Bedien- und Steuervorrichtung **(17),** ausgerichtet wird.

2. Hilfsvorrichtung nach Anspruch 1,
**dadurch gekennzeichnet,**
**dass** die Vertiefungen **(5)** und/oder Justage-Ausnehmungen **(6)** sich von einer ersten Grundfläche **(4)** des Grundkörpers **(3)** in einer Dickenrichtung **(d)** des Grundkörpers **(3)** erstrecken.

3. Hilfsvorrichtung nach Anspruch 1 oder 2,
**dadurch gekennzeichnet,**
**dass** um die Vertiefungen **(5)** jeweils umlaufend geschlossene Dichtrahmen **(8)** angeordnet sind.

4. Hilfsvorrichtung nach einem der Ansprüche 1 bis 3,
**dadurch gekennzeichnet,**
**dass** die Vertiefungen **(5)** mit angrenzenden Anschlusskanälen **(10)** zur Führung von Kabeln der Anzeigeelemente **(7)** verbunden sind.

5. Hilfsvorrichtung nach einem der Ansprüche 1 bis 4,
**dadurch gekennzeichnet,**
**dass** auf einer zweiten Grundfläche **(11),** bevorzugt in Verlängerung der Vertiefungen **(5)** in Dickenrichtung **(d),** besonders bevorzugt angrenzend an Anschlusskanäle **(10),** elektronische Kontaktmittel **(12),** bevorzugt in der Form von bedruckten Leiterplatten **(13)** (printed circuit boards: PCB), angeordnet sind.

6. Hilfsvorrichtung nach einem der Ansprüche 1 bis 5,
**dadurch gekennzeichnet,**
**dass** die Anzahl der Vertiefungen **(5)** der Anzahl der Justage-Ausnehmungen **(6)** entspricht.

7. Hilfsvorrichtung nach einem der Ansprüche 1 bis 6,
**dadurch gekennzeichnet,**
**dass** die Vertiefungen **(5)** nebeneinander in einer Reihe angeordnet sind und die Justage-Ausnehmungen **(6)** in einer Reihe neben den Vertiefungen **(5),** bevorzugt an den Vertiefungen **(5)** ausgerichtet, angeordnet sind.

8. Mehrfachanzeigebaugruppe **(2)** mit einer Hilfsvorrichtung **(1)** nach einem der Ansprüche 1 bis 7, wobei in den Vertiefungen **(5)** jeweils ein Anzeigeelement **(7)** angeordnet ist.

9. Mehrfachanzeigebaugruppe nach Anspruch 8,
**dadurch gekennzeichnet,**
**dass** die Anzeigeelemente **(7)** mit Kablen, bevorzugt mit einem Flachkabel **(9),** durch die Anschlusskanäle **(10)** mit den elektronischen Kontaktmitteln **(12)** verbunden sind.

10. Bedien- und Steuervorrichtung, bevorzugt für eine Werkzeugmaschine, mit einem Frontelement, bevorzugt einer Frontscheibe, und einem an das Frontelement angrenzenden Rahmen **(15),** wobei in Ausnehmungen des Frontelements eine Vielzahl von Schaltelementen **(16)** angeordnet sind,
**dadurch gekennzeichnet,**
**dass** im inneren des Rahmens **(15),** bevorzugt hinter dem Frontelement, eine Mehrfachanzeigebaugruppe **(2)** nach einem der Ansprüche 8 oder 9 oder eine Hilfsvorrichtung **(1)** nach einem der Ansprüche 1 bis 7 angeordnet ist, wobei die Justage-Ausnehmungen **(6)** an nach Innen in den Rahmen **(15)** vorstehenden Konturen **(18)** von Schaltelementen **(16)** ausgerichtet sind.

11. Bedien- und Steuervorrichtung nach Anspruch 10,
**dadurch gekennzeichnet,**
**dass** die nach Innen in den Rahmen **(15)** vorstehenden Konturen **(18)** der Schaltelemente **(16)** die Justage-Ausnehmungen **(6)** in Dickenrichtung **(d)** der Hilfsvorrichtung **(1)** durchgreifen.

12. Bedien- und Steuervorrichtung nach Anspruch 10 oder 11,
**dadurch gekennzeichnet,**
**dass** die die nach Innen in den Rahmen **(15)** vorstehenden Konturen **(18)** der Schaltelemente **(16)** ein Außengewinde **(19),** bevorzugt zur Befestigung der Schaltelemente **(16)** an dem Frontelement aufweisen, und der Grundkörper **(3)** der Hilfsvorrichtung **(1)** über Muttern **(21),** die auf den Außengewinden **(19)** aufgeschraubt sind, in der Bedien- und Steuervorrichtung **(17)** befestigt ist.

13. Verfahren zur Montage einer Vielzahl von Anzeigeelementen **(7)** in einer Bedien- und Steuervorrichtung **(17),** insbesondere für eine Werkzeugmaschine, umfassend die Verfahrensschritte,
- Einfügen der Vielzahl von Anzeigeelementen **(7)** in Vertiefungen **(5)** eines Grundkörpers **(3)** einer Hilfsvorrichtung **(1),** insbesondere einschließlich elektrischer Kontaktierung an Kontaktmitteln **(12)** der Hilfsvorrichtung **(1)** über Anschlusskanäle **(10)** des Grundkörpers **(3),**
- Ausrichten und Anordnen der Hilfsvorrichtung **(1)** in der Bedien- und Steuervorrichtung **(17),** indem Justage-Ausnehmungen **(6)** im Grundkörper **(3)** der Hilfsvorrichtung **(1)** an nach Innen in einen Rahmen **(15)** der Bedien- und Steuervorrichtung **(17)** vorstehenden Konturen **(18)** von Schaltelementen **(16)** der Bedien- und Steuervorrichtung **(17)** ausgerichtet werden,
- Befestigen der Hilfsvorrichtung **(1)** in der Bedien- und Steuervorrichtung **(17),** insbesondere über eine Befestigung des Grundkörpers **(3)** an den nach Innen vorstehenden Konturen **(18)** von Schaltelementen **(16).**

14. Verfahren nach Anspruch 13,
**dadurch gekennzeichnet,**
**dass** bei der Ausrichtung und Anordnung der Hilfsvorrichtung **(1)** die nach Innen in den Rahmen **(15)** vorstehenden Konturen **(18)** der Schaltelemente **(16)** zumindest teilweise durch die Justage-Ausnehmungen **(6)** geführt werden.

15. Verfahren nach Anspruch 13 oder 14,
**dadurch gekennzeichnet,**
**dass** beim Befestigen der Hilfsvorrichtung **(1)** in der Bedien- und Steuervorrichtung **(17)** der Grundkörper **(3)** der Hilfsvorrichtung **(1)** mit Muttern **(21)** befestigt wird, die auf Außengewinden **(19)** aufgeschraubt werden, die auf den nach Innen in den Rahmen **(15)** vorstehenden Konturen **(18)** der Schaltelemente **(16,16.1)** angeordnet sind und die bevorzugt zur Befestigung der Schaltelemente **(16)** an dem Frontelement dienen.
